# EUROPÄISCHE PATENTSCHRIFT

(11) **EP 1 449 415 B1**
(45) Veröffentlichungstag und Bekanntmachung des Hinweises auf die Patenterteilung: **16.03.2005**
(21) Anmeldenummer: 02791679.0
(22) Anmeldetag: 14.11.2002
(51) Int. Cl.: H05K 3/40, G06K 19/077, B26D 7/27

(54) **VERFAHREN UND VORRICHTUNG ZUM DURCHKONTAKTIEREN VON SUBSTRATEN UND LEITERPLATTEN**
METHOD AND DEVICE FOR THROUGH-HOLE PLATING OF SUBSTRATES AND PRINTED CIRCUIT BOARDS
PROCEDE ET DISPOSITIF DE METALLISATION DE SUBSTRATS ET PLAQUETTES

(30) Priorität: 16.11.2001 DE 10156395
(43) Veröffentlichungstag der Anmeldung: 25.08.2004
(73) Patentinhaber: Giesecke & Devrient GmbH, 81677 München (DE)
(72) Erfinder: USNER, Jürgen, 81375 München (DE); WELLING, Ando, 84424 Isen (DE)
(74) Vertreter: Klunker . Schmitt-Nilson . Hirsch
(86) Internationale Anmeldenummer: PCT/EP2002/012774
(87) Internationale Veröffentlichungsnummer: WO 2003/043394

(56) Entgegenhaltungen:
- DE-A- 2 107 591
- DE-A- 3 017 320
- US-A- 4 121 044
- PATENT ABSTRACTS OF JAPAN vol. 013, no. 371 (E-807), 17. August 1989 (1989-08-17) & JP 01 125892 A (MARI YAMAZAKI), 18. Mai 1989 (1989-05-18)
- PATENT ABSTRACTS OF JAPAN vol. 1996, no. 07, 31. Juli 1996 (1996-07-31) & JP 08 071981 A (BRIDGESTONE CORP), 19. März 1996 (1996-03-19)

## Beschreibung

Die Erfindung betrifft ein Verfahren und eine Vorrichtung zum Durchkontaktieren von flexiblen Substraten, insbesondere Leiterplatten, mit auf zwei einander gegenüberliegenden Oberflächen des Substrats angeordneten, elektrisch leitfähigen Kontaktzonen, wobei im Bereich der Kontaktzonen mittels einem Schneidwerkzeug ein Schnitt schräg zu den Oberflächen des Substrats durch das Substrat hindurch erzeugt wird und die beiden an den schrägen Schnitt angrenzenden Substratbereiche aneinander vorbeibewegt werden, bis sie hintereinander verrasten. Dadurch wird erreicht, dass sie die auf den gegenüberliegenden Oberflächen des Substrats angeordneten Kontaktzonen berühren, das heißt die Kontaktzone auf der Oberseite des Substrats berührt die Kontaktzone der Unterseite des Substrats.

Ein solches Verfahren ist in der unveröffentlichten Patentanmeldung DE 101 22 414.1 beschrieben. Gegenüber herkömmlichen Durchkontaktierungsverfahren, bei denen die Durchkontaktierung durch Ausstanzen oder Bohren eines Durchgangslochs und Einsetzen einer leitfähigen Kontakthülse oder Einfüllen einer leitfähigen Paste (EP-A-0 884 973) erfolgt, ist dieses Verfahren wesentlich einfacher. Die Oberflächen des Substrats können durch nachfolgendes Laminieren wieder eingeebnet werden, wobei gleichzeitig die elektrisch leitfähige Verbindung zwischen den beiden Kontaktzonen stabilisiert wird. Zusätzliches leitfähiges Material ist zur Herstellung des Kontakts nicht erforderlich, da die Kontaktzonen aufgrund der Eigenspannung des flexiblen Substrats fest gegeneinanderdrücken.

Ein solches Substrat bzw. solche Leiterplatten werden üblicherweise in IC-Karten bzw. Chipkarten (Ausweiskarten, Kreditkarten, Geldkarten, etc.) als Karteninlett integriert und bilden häufig eine separate Schicht des Kartenkörpers. Auf der einen Seite der Leiterplatte kann sich beispielsweise ein durch die leitfähige Schicht gebildeter, integrierter Schaltkreis mit weiteren elektronischen Bauelementen befinden, während die leitfähige Schicht auf der gegenüberliegenden Seite der Leiterplatte beispielsweise als Antennenspule für den kontaktlosen Datenaustausch und Energietransfer mit externen Geräten ausgebildet ist, die durch die Leiterplatte hindurch mit dem integrierten Schaltkreis elektrisch leitend verbunden ist. Diese elektrisch leitende Verbindung durch die Leiterplatte hindurch wird gemeinhin als "Durchkontaktierung" bezeichnet.

Anstelle von IC-Karten kann das Substrat im Rahmen der vorliegenden Erfindung auch für Anhänger, Aufkleber und ähnliche Sicherheitselemente mit Antennenspulentechnik und/oder elektronischen Inletts verwendet werden.

Problematisch bei diesem Verfahren stellt sich dar, dass die beiden nacheinander durchzuführenden Arbeitsschritte, nämlich der schräge Schnitt und das Durchdrücken der beiden an den Schnitt angrenzenden Substratbereiche (nachfolgend auch bezeichnet als: "Kontaktlaschen" oder "Durchkontaktierungslaschen"), unpräzise sind und zu hohen Ausschussraten führen. Interne Versuche mit dem Verfahren erforderten daher einen hohen manuellen Arbeitsaufwand.

Aufgabe der vorliegenden Erfindung ist es, ein konkretes und zuverlässiges, vereinfachtes Verfahren zum Durchkontaktieren von Leiterplatten und dergleichen sowie eine Vorrichtung zur Durchführung des Verfahrens anzugeben.

Diese Aufgabe wird gelöst durch ein Verfahren und eine Vorrichtung mit den Merkmalen der nebengeordneten Patentansprüche. In davon abhängigen Ansprüchen sind vorteilhafte Ausgestaltungen und Weiterbildungen der Erfindung angegeben.

Demnach werden die durch den schrägen Schnitt erzeugten Durchkontaktierungslaschen nicht manuell aneinander vorbeigedrückt, sondern dies geschieht mechanisch mittels einem separaten Stößel oder mittels Druckluft oder durch Anlegen eines Unterdrucks oder automatisch beim Erzeugen des schrägen Schnitts durch einen am Schneidwerkzeug fixierten Mitnahmehaken. Einzelne oder mehrere dieser Maßnahmen können auch miteinander kombiniert werden. Durch Verwendung dieser mechanischen Hilfsmittel lässt sich das Verfahren automatisieren und die Ausschussrate verringern.

Ein besonderer Vorteil ist darin zu sehen, dass die mechanischen Hilfsmittel zum Durchdrücken der Durchkontaktierungslaschen mit dem Schneidwerkzeug zum Erzeugen des schrägen Schnitts in einer gemeinsamen Bearbeitungsstation zusammengefasst werden können. Dadurch wird es insbesondere möglich, beide Bearbeitungsschritte bei unveränderter Substratposition durchzuführen, so dass die mechanischen Hilfsmittel zum Durchdrücken der Durchkontaktierungslaschen immer an einer exakt vorbestimmten Position relativ zu dem zuvor eingebrachten Schnitt an dem Substrat angreifen.

Besonders vorteilhaft ist es, wenn die beiden zur Durchkontaktierung erforderlichen Schritte in einem gemeinsamen Arbeitsgang erfolgen. Dieses Ziel kann beispielsweise durch das Schneidwerkzeug mit daran fixiertem Mitnahmehakerr erreicht werden, indem das Schneidwerkzeug zunächst schräg zur Substratebene durch das Substrat hindurchgestoßen wird und eine der beiden dadurch erzeugten Durchkontaktierungslaschen beim weiteren Voranschieben des Schneidwerkzeugs beispielsweise durch einen an dem Schneidwerkzeug fixierten Mitnahmehaken hinter die andere Durchkontaktierungslasche gedrückt wird.

Auch bei Anwendung von Druckluft und/oder Unterdruck lassen sich die beiden Schritte - Schnitterzeugung und Durchdrücken der Lasche - in einen Arbeitsgang integrieren.

Selbst die Verwendung eines separaten Stößels zum Durchdrücken einer Kontaktierungslasche hinter die andere Kontaktierungslasche ist in den Arbeitsschritt des Erzeugens des schrägen Schnitts integrierbar. In diesem Falle werden die Kontaktierungslaschen mittels dem Stößel aneinander vorbeigedrückt, bevor das Schneidwerkzeug aus dem schrägen Schnitt zurückgezogen wird. Das Schneidwerkzeug ist vorzugsweise als Messerblatt realisiert, welches senkrecht zur Messerblattebene federn kann.

Gemäß einer besonderen Ausführungsform der Erfindung ist die Schneidkante des Schneidwerkzeugs gezahnt und besitzt mindestens einen Zahn. Dadurch wird ein Verrutschen des Messers nach dem Aufsetzen auf das flexible Substrat verhindert und die Präzision der Durchkontaktierung entsprechend verbessert.

Nachfolgend wird die Erfindung beispielhaft anhand der begleitenden Zeichnungen beschrieben. Darin zeigen:
Figur 1a und 1b die Vorderseite und die Rückseite eines flexiblen Substrats,
Figur 2 zwei Ausführungsbeispiele einer erfindungsgemäßen Vorrichtung zum Durchkontaktieren des Substrats in Seitenansicht,
Figur 3a und 3b ein mittels der Vorrichtung nach Figur 2 durchkontaktiertes Substrat im Querschnitt und in Draufsicht,
Figur 4 eine Ausgestaltung der erfindungsgemäßen Vorrichtung nach Figur 2,
Figur 5a und 5b ein mittels der Vorrichtung nach Figur 4 durchkontaktiertes Substrat im Querschnitt und in Draufsicht,
Figur 6 zwei weitere Ausführungsbeispiele einer erfindungsgemäßen Vorrichtung zum Durchkontaktieren des Substrats in Seitenansicht, und
Figur 7 ein Schneidwerkzeug mit gezahnter Schneidkante.

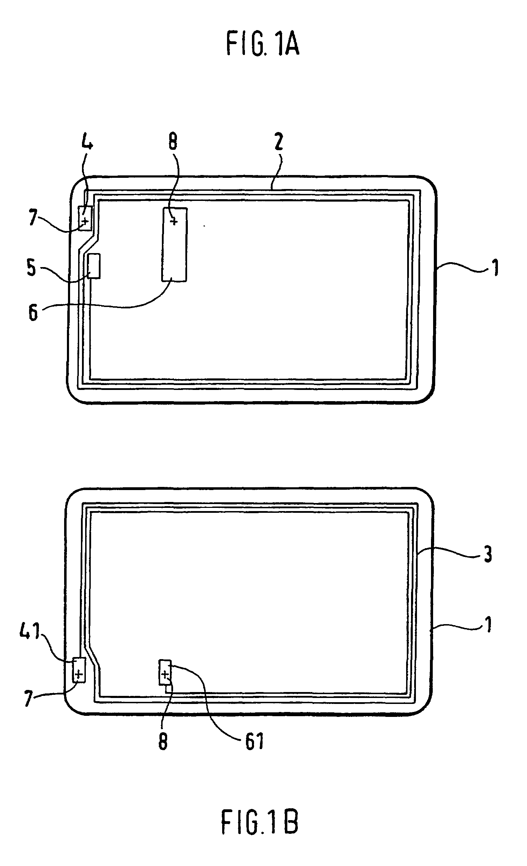

Figur 1a zeigt die Vorderseite eines Substrats 1, welches zum Einbau in einen. Kartenkörper geeignet ist. Auf dieser Seite des Substrats ist eine leitfähige Schicht 2 in Form einer Spule für den kontaktlosen Daten- und Energieaustausch mit einem externen Gerät dargestellt. Die auf dieser Seite des Substrats 1 angeordnete Spule 2 weist die Kontaktzonen 4 und 5 auf, wobei die Kontaktzone 5 zur Kontaktierung mit einem IC-Modul vorgesehen ist. Eine weitere Kontaktierung der Spule mit dem IC-Modul erfolgt über die Kontaktzone 6, welche mittels einer Durchkontaktierung an der Stelle 8 mit einer zweiten elektrisch leitfähigen Schicht 3 in Form einer zweiten Spule auf der Rückseite des Substrats 1 verbunden ist (Figur 1b). Eine weitere Durchkontaktierung der selben Art verbindet die Kontaktzone 4 mit der Spule 3 an der Stelle 7. Die zugehörigen Kontaktzonen der Spule 3 auf der Rückseite des Substrats sind mit 61 und 41 in Figur 1b gekennzeichnet.

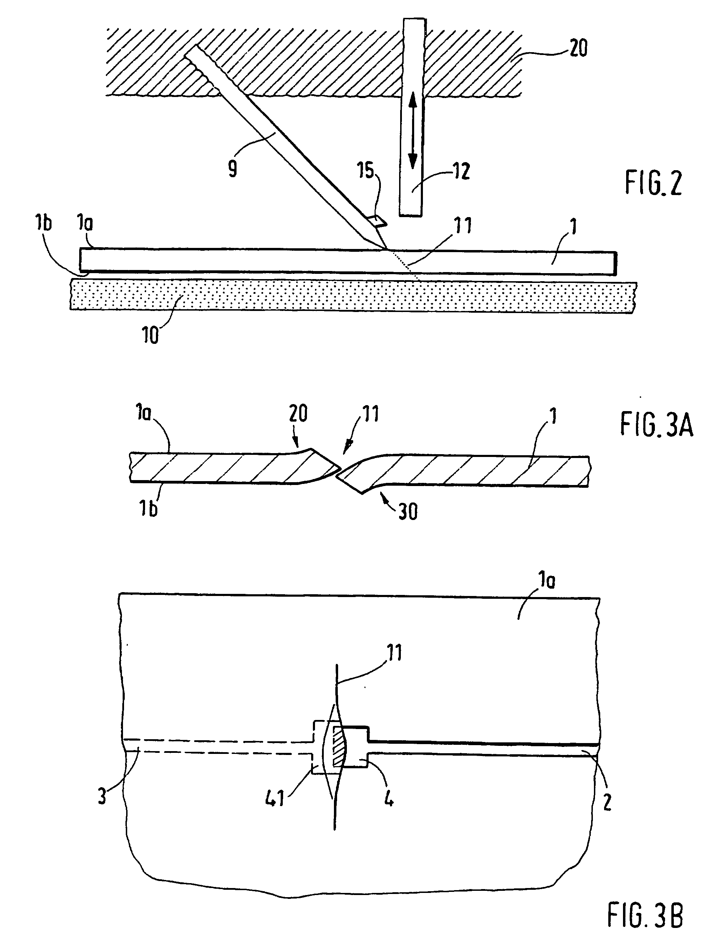

In Figur 2 sind zwei Ausführungsformen einer erfindungsgemäßen Vorrichtung zur Durchführung der Durchkontaktierung gemeinsam dargestellt. Beiden Ausführungsformen ist gemeinsam, dass das Substrat 1 in einer Verarbeitungsstation auf einer weichen Unterlage 10, beispielsweise einer Gummimatte, aufliegt und bei unveränderter Position des Substrats sowohl ein Schnitt 11 schräg zu den Oberflächen 1a, 1b des Substrats 1 erzeugt wird als auch die durch den Schnitt gebildeten Durchkontaktierungslaschen 20, 30 aneinander vorbeigedrückt werden, bis die Lasche 30 hinter der anderen Lasche 20 einrastet, wie in Figur 3a dargestellt ist.

Der Schnitt 11 im Substrat 1 wird vorzugsweise mit einem 45°-Winkel relativ zu den Substratoberflächen 1a, 1b erzeugt.

Der Schritt des aneinander Vorbeibewegens der beiden Durchkontaktierungslaschen 20,30 erfolgt gemäß der ersten in Figur 2 dargestellten Ausführungsform mittels einem Mitnahmehaken 15 am Messer 9. Dazu wird das im Messerblock 20 verschieblich gelagerte Messer 9 zunächst in axialer Richtung vorgeschoben, um den Schnitt 11 zu erzeugen. Durch weiteres Voranschieben des Messers 9 kommt der Mitnahmehaken 15 in Kontakt mit der in Figur 2 rechts vom Schnitt 11 liegenden Kontaktlasche 30 und drückt diese zurück bis hinter die in Figur 2 links vom Schnitt 11 liegende Kontaktlasche 20, so dass die beiden Kontaktlaschen hintereinander verrasten (Figur 3a).

Gemäß der zweiten in Figur 2 dargestellten Ausführungsform wird zum aneinander Vorbeibewegen der beiden Durchkontaktierungslaschen 20, 30 anstelle des Mitnahmehakens 15 ein Stößel 12 eingesetzt, der in Pfeilrichtung auf- und abbewegbar ist. In diesem Falle wird zunächst der Schnitt 11 mittels dem Messer 9 durch Voranschieben des Messers 9 in dessen Axialrichtung erzeugt und anschließend, bevor oder nachdem das Messer 9 in seine Ausgangsposition zurückbewegt wurde, wird mittels dem Stößel 12 wiederum die rechts vom Schnitt 11 liegende Kontaktlasche 30 hinter die links vom Schnitt 11 liegende Kontaktlasche 20 gedrückt. Der Stößel 12 besitzt in diesem Falle einen vergleichsweise kleinen Querschnitt und drückt mit diesem Querschnitt lediglich den zentralen Bereich der rechten Kontaktlasche 30 unter die linke Kontaktlasche 20.

In Draufsicht ergibt sich für beide Ausführungsformen eine durchkontaktierte Konfiguration wie in Figur 3b gezeigt. Demnach überlappen sich die Kontaktlaschen 20, 30 mit ihren Oberflächen 1a, 1b (Figur 3a) nur in einem zentralen Bereich des Schnitts 11. Der dadurch hergestellte Kontaktbereich zwischen den Kontaktzonen 4 der Spule 2 und der Kontaktzone 41 der Spule 3 ist in Figur 3b schraffiert dargestellt.

Nachdem die Durchkontaktierung in der Bearbeitungsstation vollendet ist, kann das Substrat 1 der Bearbeitungsstation entnommen werden und beispielsweise in einem Laminierprozess mit weiteren Kunststoffschichten und gegebenenfalls mit weiteren elektronischen Bauelementen zu einer Kunststoffkarte fertiggestellt werden.

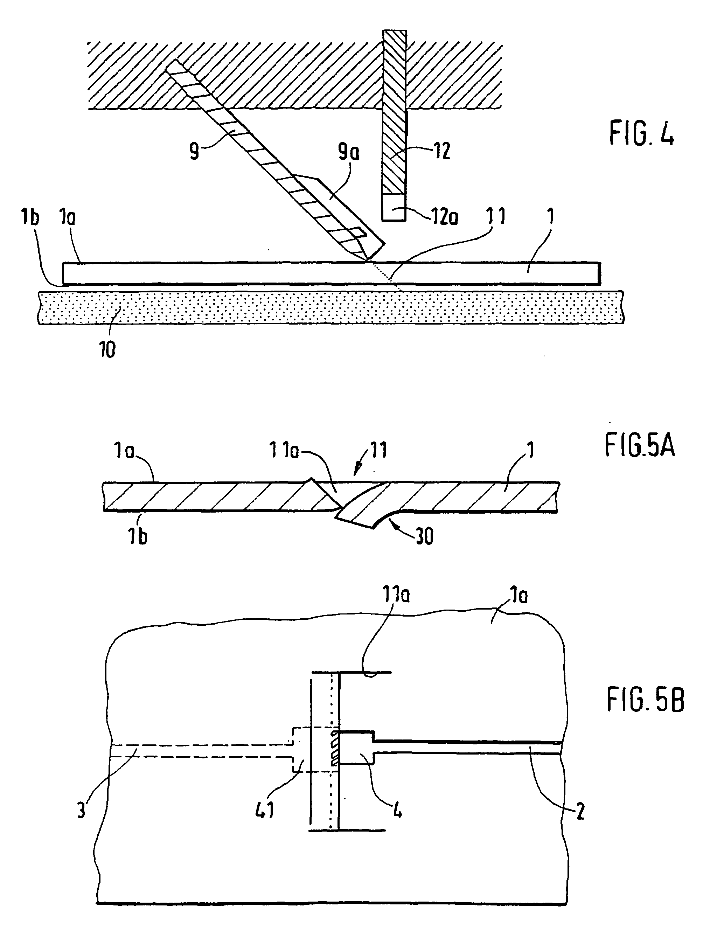

Statt des in Figur 2 gezeigten Stößels mit vergleichsweise kleinem Querschnitt kann auch ein Stößel verwendet werden, der sich entlang der gesamten Länge des Schnitts 11 erstreckt. Auch der Mitnahmehaken 15, der bei der Ausführungsform nach Figur 2 vorzugsweise vergleichsweise klein und mittig auf dem Messer 9 platziert ist, kann sich gegebenenfalls über die gesamte Breite des Messers 9 erstrecken. In diesem Falle führt das Durchdrükken der rechten Kontaktlasche 30 hinter die linke Kontaktlasche 20 dazu, dass zumindest die durchgedrückte Kontaktlasche 30 an den beiden Schnittenden einreißen wird. Um dies zu vermeiden, sehen die in Figur 4 dargestellten alternativen Ausgestaltungen zu der Vorrichtung aus Figur 2 vor, dass das Messer 9 seitliche Schneidelemente 9a bzw. der Stößel 12 seitliche Schneidelemente 12a besitzt, die dafür sorgen, dass entweder beim Erzeugen des Schnitts 11 mittels der Schneidelemente 9a oder beim aneinander Vorbeidrücken der Kontaktlaschen mittels der Schneidelemente 12a ein sauberer Schnitt 11a senkrecht zur Querausdehnung des Schnitts 11 erzeugt wird. Die Durchkontaktierungslasche 30 besitzt dann eine typische Laschenform im strengeren Sinne, wie in Figur 5a an der rechten, nach unten aus der Substratebene herausgedrückten Kontaktierungslasche 30 zu erkennen ist. Diese Kontaktlasche 30 ist an drei Seiten von dem Substrat 1 durch die Schnitte 11 und 11a getrennt und nur noch an einer Seite mit dem Substrat 1 verbunden. In Figur 5b ist der Bereich der mittels der Vorrichtung aus Figur 4 erzeugten Durchkontaktierung wiederum in Draufsicht dargestellt. Die konkret kontaktierte Fläche zwischen den Kontaktzonen 4 und 41 ist wiederum schraffiert.

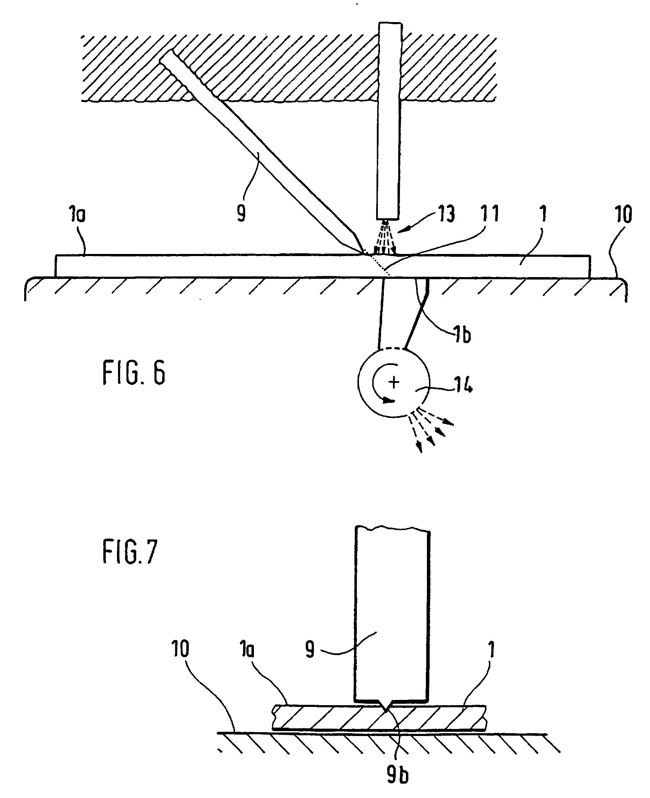

In Figur 6 sind zwei weitere Ausführungsformen einer erfindungsgemäßen Vorrichtung zur Durchführung des Verfahrens wiederum in einem Bild gemeinsam dargestellt. In diesem Falle wird die rechte Kontaktlasche 30 mittels Druckluft 13, die auf die Vorderseite 1a der Kontaktlasche 30 gerichtet ist, und/ oder mittels Unterdruck, der von einer Vakuumpumpe 14 an der Rückseite 1b der Kontaktlasche angelegt wird, an der linken Kontaktlasche 20 vorbeibewegt. In diesem Falle kann die Unterlage 10 eine feste Unterlage sein, da der Schnitt 11 in den Ansaugstutzen der Vakuumpumpe 14 hineingeführt wird und auch die rechts vom Schnitt 11 liegende Durchkontaktierungslasche 30 beim Vorbeibewegen an der links vom Schnitt 11 liegenden Kontaktierungslasche 20 in diesen Ansaugstutzen hineinbewegt wird.

Figur 7 zeigt eine besondere Ausführungsform des Messers 9, welches eine gezahnte Schneidkante besitzt. In dem konkret dargestellten Ausführungsbeispiel besitzt die Schneidkante des Messers 9 einen einzigen Zahn 9b, der dazu dient, ein Verrutschen des Messers 9 nach dem Aufsetzen auf die Oberfläche 1a des Substrats 1 zu verhindern.

## Patentansprüche

1. Verfahren zum Durchkontaktieren von flexiblen Substraten (1) mit auf zwei einander gegenüberliegenden Oberflächen (1a, 1b) des Substrats (1) angeordneten, elektrisch leitfähigen Kontaktzonen (4, 41; 6, 61), wobei im Bereich der Kontaktzonen (4,41) mittels einem Schneidwerkzeug (9) ein Schnitt (11) schräg zu den Oberflächen (1a, 1b) des Substrats (1) durch das Substrat hindurch erzeugt wird, **dadurch gekennzeichnet, dass** die beiden an den schrägen Schnitt (11) angrenzenden Substratbereiche (20, 30) aneinander vorbeibewegt werden, bis sie hintereinander verrasten, wobei der Schritt des aneinander Vorbeibewegens zusammen mit der Erzeugung des Schnitts in einem Arbeitsgang ausgeführt wird.

2. Verfahren nach Anspruch 1, **dadurch gekennzeichnet, dass** die aneinandergrenzenden Substratbereiche (20, 30) mittels eines separaten Stößels (12) und/ oder einer am Schneidwerkzeug angeordneten Mitnahmevorrichtung (15) aneinander vorbeibewegt werden.

3. Verfahren nach Anspruch 1 oder 2, **dadurch gekennzeichnet, dass** die aneinandergrenzenden Substratbereiche (20, 30) durch Druckluft (13) oder Erzeugung von Unterdruck (14) aneinander vorbeibewegt werden.

4. Verfahren nach einem der Ansprüche 1 bis 3, **dadurch gekennzeichnet, dass** die beiden Schritte der Schnitterzeugung und des aneinander Vorbeibewegens der beiden Substratbereiche bei unveränderter Substratposition durchgeführt werden.

5. Verfahren nach einem der Ansprüche 1 bis 4, **dadurch gekennzeichnet, dass** der schräge Schnitt (11) mit einem Winkel von 45° zu den Substratoberflächen (1a, 1b) erzeugt wird.

6. Vorrichtung zur Durchführung des Verfahrens nach einem der Ansprüche 1 bis 5, umfassend ein Schneidwerkzeug (9) zum Erzeugen eines Schnitts (11) durch ein Substrat (1) hindurch schräg zu zwei einander gegenüberliegenden Oberflächen (1a, 1b) des Substrats und eine Einrichtung (12; 13; 14; 15) zum aneinander Vorbeibewegen und hintereinander Verrasten von zwei an den Schnitt (11) angrenzenden Substratbereichen (20, 30), **dadurch gekennzeichnet, dass** das Schneidwerkzeug (9) und die Verrasteinrichtung (12; 13; 14; 15) in einer gemeinsamen Arbeitsstation angeordnet sind.

7. Vorrichtung nach Anspruch 6, **dadurch gekennzeichnet, dass** die Verrasteinrichtung einen Stößel (12) umfasst.

8. Vorrichtung nach Anspruch 6 oder 7, **dadurch gekennzeichnet, dass** die Verrasteinrichtung zum aneinander Vorbeibewegen der beiden an den Schnitt angrenzenden Substratbereiche Druckluft (13) einsetzt.

9. Vorrichtung nach einem der Ansprüche 6 bis 8, **dadurch gekennzeichnet, dass** die Verrasteinrichtung zum aneinander Vorbeibewegen der beiden an den Schnitt angrenzenden Substratbereiche Unterdruck (14) einsetzt.

10. Vorrichtung nach Anspruch 6, **dadurch gekennzeichnet, dass** die Verrasteinrichtung einen am Schneidwerkzeug (9) fixierten Mitnahmehaken (15) umfasst.

11. Vorrichtung nach einem der Ansprüche 6 bis 10, **dadurch gekennzeichnet, dass** das Schneidwerkzeug (9) eine Schneidkante mit mindestens einem Zahn (9b) besitzt.

12. Vorrichtung nach einem der Ansprüche 6 bis 11, **dadurch gekennzeichnet, dass** das Schneidwerkzeug (9) ein Messerblatt umfasst, welches senkrecht zur Messerblattebene federn kann.

## Claims

1. A method for through-contacting flexible substrates (1) having electrically conductive contact zones (4, 41; 6, 61) disposed on two opposing surfaces (1a, 1b) of the substrate (1), whereby a cut (11) is produced by means of a cutting tool (9) through the substrate obliquely to the surfaces (1a, 1b) of the substrate (1) in the area of the contact zones (4, 41), **characterized in that** the two substrate areas (20, 30) adjoining the oblique cut (11) are moved past each other until they lock behind each other, the step of moving them past each other being performed in one operation with the production of the cut.

2. A method according to claim 1, **characterized in that** the adjoining substrate areas (20, 30) are moved past each other by means of a separate ram (12) and/or a driving device (15) disposed on the cutting tool.

3. A method according to claim 1 or 2, **characterized in that** the adjoining substrate areas (20, 30) are moved past each other by compressed air (13) or production of a vacuum (14).

4. A method according to any of claims 1 to 3, **characterized in that** the two steps of producing the cut and moving the two substrate areas past each other are performed with the substrate position unchanged.

5. A method according to any of claims 1 to 4, **characterized in that** the oblique cut (11) is produced at an angle of 45° to the substrate surfaces (1a, 1b).

6. An apparatus for carrying out the method according to any of claims 1 to 5, comprising a cutting tool (9) for producing a cut (11) through a substrate (1) obliquely to two opposing surfaces (1a, 1b) of the substrate, and a device (12; 13; 14; 15) for moving two substrate areas (20, 30) adjoining the cut (11) past each other and locking them behind each other, **characterized in that** the cutting tool (9) and the locking device (12; 13; 14; 15) are disposed in a common work station.

7. An apparatus according to claim 6, **characterized in that** the locking device comprises a ram (12).

8. An apparatus according to claim 6 or 7, **characterized in that** the locking device uses compressed air (13) for moving the two substrate areas adjoining the cut past each other.

9. An apparatus according to any of claims 6 to 8, **characterized in that** the locking device uses a vacuum (14) for moving the two substrate areas adjoining the cut past each other.

10. An apparatus according to claim 6, **characterized in that** the locking device comprises a driving hook (15) fixed to the cutting tool (9).

11. An apparatus according to any of claims 6 to 10, **characterized in that** the cutting tool (9) has a cutting edge with at least a tooth (9b).

12. An apparatus according to any of claims 6 to 11, **characterized in that** the cutting tool (9) comprises a knife blade which is resilient perpendicular to the knife blade plane.

## Revendications

1. Procédé pour établir un contact à travers des substrats souples (1) ayant des zones de contact (4, 41 ; 6, 61) électriquement conductrices agencées sur deux surfaces (1a, 1b) opposées du substrat (1), dans lequel une incision (11) oblique aux surfaces (1a, 1b) du substrat (1) est réalisée à travers le substrat dans la région des zones de contact (4, 41) au moyen d'un outil de coupe (9), **caractérisé en ce que** les deux régions (20, 30) du substrat contiguës à l'incision oblique (11) sont déplacées en passant l'une devant l'autre jusqu'à venir s'encliqueter l'une derrière l'autre, l'étape de déplacement en passant l'une devant l'autre étant exécutée en même temps que la réalisation de l'incision en une seule opération.

2. Procédé selon la revendication 1, **caractérisé en ce que** les deux régions contiguës (20, 30) du substrat sont déplacées en passant l'une devant l'autre au moyen d'un poussoir (12) et/ou d'un dispositif d'entraînement (15) agencé sur l'outil de coupe.

3. Procédé selon la revendication 1 ou 2, **caractérisé en ce que** les deux régions contiguës (20, 30) du substrat sont déplacées en passant l'une devant l'autre au moyen d'air comprimé (13) ou par création d'une dépression (14).

4. Procédé selon l'une des revendications 1 à 3, **caractérisé en ce que** les deux étapes de réalisation de l'incision et de déplacement des deux régions contiguës (20, 30) du substrat en passant l'une devant l'autre sont exécutées sans modification de la position du substrat.

5. Procédé selon l'une des revendications 1 à 4, **caractérisé en ce que** l'incision oblique (11) est formée avec un angle de 45° par rapport aux surfaces (1a, 1b) du substrat.

6. Dispositif pour mettre en oeuvre le procédé selon l'une des revendications 1 à 5, comprenant un outil de coupe (9) pour réaliser à travers un substrat (1) une incision (11) oblique par rapport à deux surfaces opposées (1a, 1b) du substrat et un agencement (12 ; 13 ; 14 ; 15) pour déplacer deux régions du substrat contiguës (20, 30) à l'incision (11) en passant l'une devant l'autre et les encliqueter l'une derrière l'autre, **caractérisé en ce que** l'outil de coupe (9) et l'agencement d'encliquetage (12 ; 13 ; 14 ; 15) sont agencés dans un poste de travail commun.

7. Dispositif selon la revendication 6, **caractérisé en ce que** l'agencement d'encliquetage comprend un poussoir (12).

8. Dispositif selon la revendication 6 ou 7, **caractérisé en ce que** l'agencement d'encliquetage emploie de l'air comprimé (13) pour déplacer en passant l'une devant l'autre les deux régions du substrat contiguës (20, 30) à l'incision (11).

9. Dispositif selon l'une des revendications 6 à 8, **caractérisé en ce que** l'agencement d'encliquetage emploie une dépression (14) pour déplacer en passant l'une devant l'autre les deux régions du substrat contiguës (20, 30) à l'incision (11).

10. Dispositif selon la revendication 6, **caractérisé en ce que** l'agencement d'encliquetage comprend un crochet d'entraînement (15) fixé à l'outil de coupe (9).

11. Dispositif selon l'une des revendications 6 à 10, **caractérisé en ce que** l'outil de coupe (9) comprend une arête de coupe ayant au moins une dent (9b).

12. Dispositif selon l'une des revendications 6 à 11, **caractérisé en ce que** l'outil de coupe (9) comprend une lame de couteau pouvant faire ressort perpendiculairement au plan de la lame de couteau.
